# EUROPÄISCHE PATENTSCHRIFT

(11) **EP 0 836 097 B1**
(45) Veröffentlichungstag und Bekanntmachung des Hinweises auf die Patenterteilung: **20.07.2005**
(21) Anmeldenummer: 97117312.5
(22) Anmeldetag: 07.10.1997
(51) Int. Cl.: G01R 1/067

(54) **Messspitzeneinheit**
Measuring probe
Sonde de mesure

(30) Priorität: 10.10.1996 DE 19641880
(43) Veröffentlichungstag der Anmeldung: 15.04.1998
(73) Patentinhaber: Rosenberger Hochfrequenztechnik GmbH & Co., 84526 Tittmoning (DE)
(72) Erfinder: Heuermann, Holger, Dr. Ing., 84529 Tittmoning (DE)
(74) Vertreter: Graf, Walter, Dipl.-Ing.

(56) Entgegenhaltungen:
- EP-A- 0 367 542
- DE-A- 1 516 121
- US-A- 4 871 964
- US-A- 4 894 612
- US-A- 5 045 781
- US-A- 5 506 515

## Beschreibung

Die Erfindung betrifft eine Meßspitzeneinheit zum Kontaktieren von planaren Mikrowellenschaltungen.

Es sind Meßspitzeneinheiten für Mikrowellen-Wafer-Meßeinrichtungen (Wafer-Prober) bekannt, bei denen das zum Meßgerät, beispielsweise einem vektoriellen Netzwerkanalysator, führende Koaxialkabel unmittelbar in Kontaktspitzen übergeht (US Patent 4 871 964 bzw. Firmendruckschrift "Pico-Probe" der Firma GGB Industries, Inc.). Der Innenleiter des Koaxialkabels ist über den Außenleiter hinaus verlängert, zum Ende hin zugespitzt und krallenförmig nach unten gebogen. Am Außenleiter des Koaxialkabels ist mindestens auf einer Seite eine ebenfalls krallenförmig nach unten gebogene Kontaktfeder befestigt. Diese bekannten Meßspitzen verschleißen bei Gebrauch relativ schnell innerhalb von Monaten, es besteht außerdem die Gefahr, daß durch Fehlsteuerungen beim Aufsetzen der Meßspitzen diese brechen. Dann muß die gesamte Meßspitzeneinheit ausgetauscht und erneuert werden.

Ähnliches gilt für eine andere bekannte Meßspitzeneinheit, bei der die Meßspitzen in koplanarer Leitungstechnik ausgebildet sind (Europäische Patentschrift 0 367 542). Die eigentliche Meßspitze besteht aus einem dreieckförmigen dielektrischen Substrat, auf dessen Rückseite eine Koplanarleitung ausgebildet ist. Das die Koplanarleitung tragende Substrat ist relativ empfindlich gegen Verschleiß und Bruch. Beim Justieren der Meßspitzeneinheit unter dem Mikroskop wird die Meßstelle relativ großflächig durch das Substrat abgedeckt, es sind nur die Enden der Koplanarleitung sichtbar, die Justierung ist daher sehr erschwert und ungenau.

Es ist Aufgabe der Erfindung, eine Meßspitzeneinheit zu schaffen, die einfach und preiswert herstellbar, unempfindlich gegen Beschädigungen und verschleißarm ist und trotzdem einfach handbabbar und universell einsetzbar ist.

Diese Aufgabe wird ausgehend von einer Meßspitzeneinheit laut Oberbegriff des Hauptanspruches durch dessen kennzeichnende Merkmale gelöst. Vorteilhafte Weiterbildungen ergeben sich aus den Unteransprüchen.

Durch die Ausbildung der Meßspitzen als Nadeln aus elastischem Federstahlmaterial ist ein Abbrechen der Meßspitzen praktisch ausgeschlossen, die Nadeln sind auch wesentlich haltbarer und verschleißen nicht so schnell und müssen daher weniger oft ersetzt werden. Beim Auswechseln der Meßspitzen muß nur die Verbindung zwischen den Nadeln und der Koplanarleitung gelöst werden, und es kann dann nur das reine Verschleißteil ausgewechselt werden. Die Meßspitzen in Form von Nadeln können unterm Mikroskop sehr genau auf die Meßstelle der Mikrowellenschaltung aufgesetzt werden, da zwischen den Nadeln freier Durchblick besteht und die Mikrowellenschaltung auch unterhalb der Nadeln sichtbar bleibt.

Die zwischen Koaxialleitungsanschluss und Kontaktspitzen zwischengeschaltete Koplanarleitung ermöglicht den einfachen Aufbau von universell einsetzbaren Messspitzeneinheiten mit den verschiedenartigsten Eigenschaften, die jeweils für spezielle Anwendungsfälle gewünscht werden. So kann beispielsweise durch Einbau einer Impedanztransformationsschaltung in die Koplanarleitung des Gehäuses eine beliebige Eingangsimpedanz zwischen den Kontaktspitzen hergestellt werden, wie dies für spezielle Messaufgaben vorteilhaft sein kann. Es besteht sogar die Möglichkeit, dass im Gehäuse in die Koplanarleitung beliebige passive und/oder sogar aktive Mikrowellenschaltungen integriert werden, also beispielsweise Teile der an die Messspitzeneinheit angeschlossenen Messgeräte.

Für den Übergang vom Koaxialleitungsanschluss auf die Koplanarleitung können übliche bekannte Übergänge benutzt werden, wie sie beispielsweise die US Patentschriften US 4,871,964, US 5,506,515 und US 4,894,612 zeigen. Ein besonders geeigneter einfacher und preiswerter Übergang ergibt sich aus den Unteransprüchen 14 und 15.

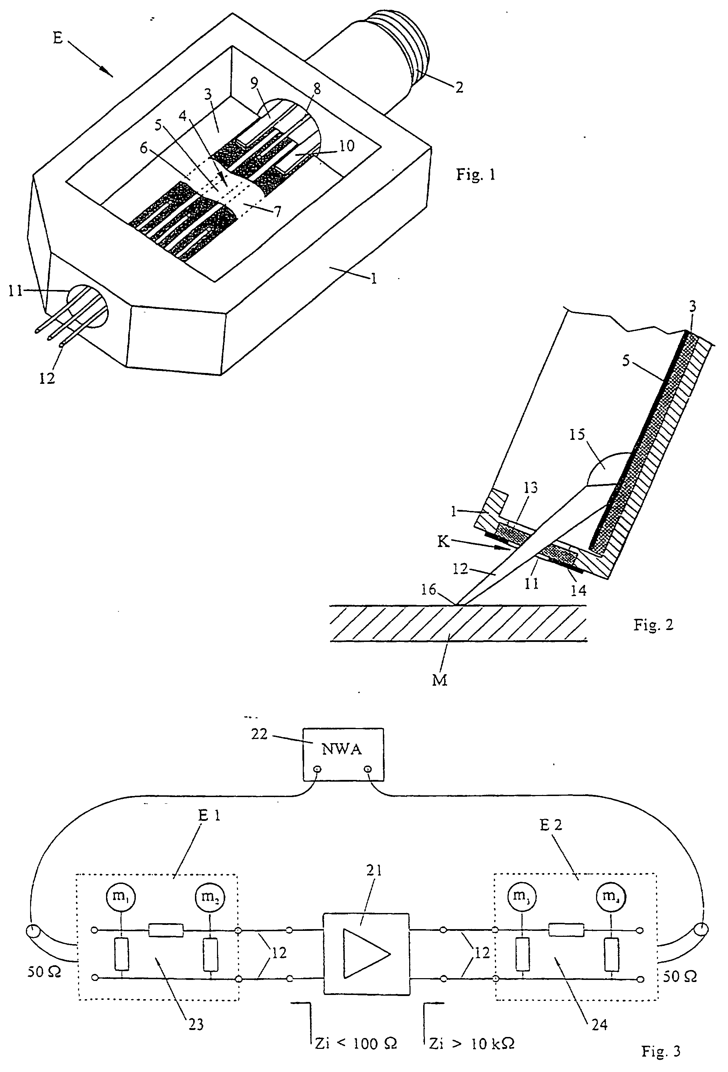

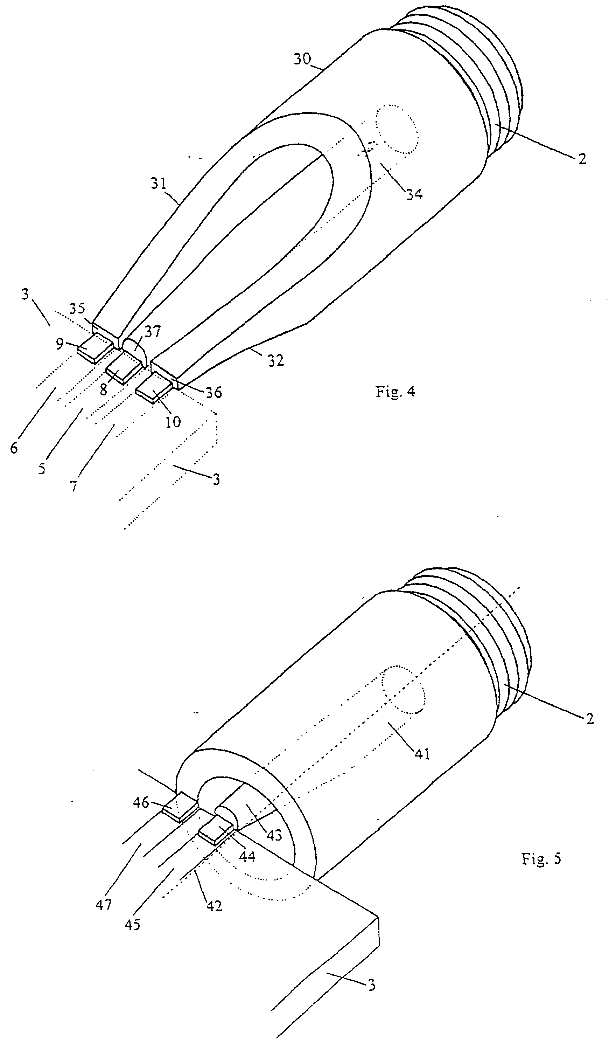

Unter Koplanarleitung werden gemäß der Erfindung Mikrowellenleitungen verstanden, bei denen alle Streifenleiter auf derselben Seite des Substrats ausgebildet sind, also beispielsweise eine aus drei nebeneinander angeordneten Streifenleiter bestehende symmetrische Koplanarleitung (koplanare Dreibandleitung) bzw. symmetrische oder unsymmetrische Zweibandleitungen, wie sie beispielsweise bei Zinke/Brunswig, Hochfrequenztechnik 1, 5. Auflage, Seite 157, Abb. 4.7/1e,f und g dargestellt sind.

Die Erfindung wird im folgenden anhand schematischer Zeichnungen an Ausführungsbeispielen näher erläutert.

Fig. 1 zeigt in vergrößerter perspektivischer Ansicht eine erfindungsgemäße Meßspitzeneinheit E bestehend aus einem mit abgenommenem Deckel dargestellten flachen Metallgehäuse 1 und einem an der einen Stirnseite ausgebildeten Koaxialleitungsanschluß 2 in Form eines Koaxialsteckers, an dem ein zu einem nicht dargestellten Meßgerät, beispielweise einen Netzwerkanalysator, führendes Koaxialkabel anschraubbar ist. Am Boden des Gehäuses 1 ist ein Mikrowellensubstrat 3 angebracht, auf dem eine Koplanarleitung 4 ausgebildet ist, die sich von der einen dem Koaxialleitungsanschluß 2 zugewandten Stirnseite des Gehäuses bis zur gegenüberliegenden Stirnseite erstreckt. In dem gezeigten Ausführungsbeispiel ist diese Koplanarleitung als Dreibandleitung ausgebildet und besteht aus einem Mittel-Streifenleiter 5 und durch Schlitze davon getrennten seitlichen Masse-Streifenleitern 6 und 7. Der Koaxialleitungsanschluß 2 geht über in drei nebeneinander angeordneten Anschlußfahnen 8, 9, 10, die mittlere Anschlußfahne 8 ist mit dem Innenleiter und die seitlichen Anschlußfahnen 9 und 10 sind mit dem Außenleiter des Koaxialleitungsanschlusses 2 verbunden. Diese Anschlußfahnen 8, 9, 10 ragen durch eine Öffnung in der Stirnwand des Gehäuses 1 nach innen und liegen mit Druck flach auf der Oberfläche der Streifenleiter 5, 6 und 7 der Koplanarleitung auf. Falls die Kontaktgabe durch Druck nicht ausreicht, können die Anschlußfahnen mit den Streifenleitern auch noch durch Löten oder Bonddrähte elektrisch verbunden sein.

In der dem Koaxialstecker 2 gegenüberliegenden Stirnseite des Gehäuses 1 ist eine Öffnung 11 ausgebildet, durch welche drei im Abstand nebeneinander angeordnete dünne Nadeln 12 aus dem Gehäuseinneren nach außen ragen. Im Gehäuse sind diese Nadeln 12 mit den drei Streifenleitern 5, 6, 7 der Koplanarleitung verbunden. Details dieser Nadelanordnung zeigt das vergrößerte Schnittbild nach Fig. 2. Die Nadeln 12 sind nebeneinander in einem Körper 13 aus Isoliermaterial eingesetzt, der über einen Haltering 14 in der Öffnung 11 des Gehäuses lösbar befestigt ist. Die Nadeln besitzen rechteckigen oder runden Querschnitt und sind leicht konisch ausgebildet, ihr dünneres äußeres Ende 16 und ihr dickeres innenliegendes Ende ist jeweils meißelförmig angeschrägt. Die Nadeln 12 sind außerdem mit ihren Enden 16 aufeinander zulaufend im Körper 13 eingesetzt, so daß die Spitzen 16 den für die Kontaktierung mit der zu messenden Mikrowellenschaltung M erforderlichen geringen Abstand von nur einigen um besitzen, während die im Gehäuse liegenden Enden den durch die Streifenleiter 5, 6, 7 der Koplanarleitung vorgegebenen Abstand besitzen. Der gegenseitige konische Abstand der Nadeln 12 und ihr konischer Durchmesser ist unter berücksichtigung der Dielektrizitätskonstante des Isolierkörpers 13 so gewählt, daß zwischen den Spitzen 16 der Nadeln 12 eine für den jeweiligen Anwendungsfall vorbestimmte Impedanz besteht. Die meißelförmige Anschrägung der Spitzen 16 ist außerdem so gewählt, daß bei einem in Fig. 2 dargestellten schrägen Aufsetzen der Meßspitzeneinheit E die Nadelenden einen Flächenkontakt mit den zu kontaktierenden Bereichen der Mikrowellenschaltung M herstellen. Auch die inneren meißelförmig angeschrägten dickeren Enden der konischen Nadeln 12 liegen mit Flächenkontakt auf den Oberflächen der Streifenleiter 5, 6, 7 auf und werden wiederum vorzugsweise nur durch Druck in Kontakt damit gehalten. Bei Bedarf kann auch hier eine zusätzliche elektrische Verbindung beispielsweise in Form von Bonddrähten 15 vorgesehen sein. Der Durchmesser der Nadeln am dickeren Ende liegt beispielsweise zwischen 0,5 und 1 mm und am äußeren spitzen Ende zwischen 50 bis 100 µm.

Bei Verschleiß oder Beschädigung der Nadeln wird die aus den drei Nadeln 12 und dem Körper 13 aus Isoliermaterial bestehende Kontaktspitzeneinheit K nach Lösen des Halterings 14 einfach aus der Gehäuseöffnung 11 herausgenommen und durch eine neue Kontaktspitzeneinheit ersetzt, damit kann bei einer Meßspitzeneinheit E sehr preiswert nur das Verschleißteil erneuert werden und die teueren Teile wie Gehäuse, Koplanarleitung und Koaxialstecker werden beibehalten.

In dem gezeigten Ausführungsbeispiel mit durchgehender Koplanarleitung 4 zwischen beispielsweise 50 Ω-Koaxialleitungsanschluß 2 und den in einem für eine Eingangsimpedanz von 50 Ω vorgegebenen Abstand angeordneten Nadeln 12 besitzt die Meßspitzeneinheit E eine Eingangsimpedanz von 50 Ω und ist damit für Messungen in 50 Ω Systemen geeignet. Eine Meßspitzeneinheit E nach Fig. 1 kann jedoch auch auf einfache Weise auf andere Eingangsimpedanzen zwischen den Meßspitzen umgerüstet werden. Dazu ist es nur erforderlich, in die Koplanarleitung 5, 6, 7 beispielsweise in deren Mitte eine entsprechende Impedanztransformationsschaltung einzubauen und die Abstände der Nadeln 12 entsprechend dieser gewünschten Impedanz zu wählen. Auf diese Weise kann beispielsweise zwischen den Meßspitzen eine Eingangsimpedanz im Bereich von einigen Ω bis einigen kΩ gewählt werden, während die Verbindung zum Meßgerät weiterhin über ein 50 Ω Koaxialkabel erfolgt.

Anstelle der aus drei Streifenleitern 5,6, 7 bestehenden Koplanarleitung könnte auch eine aus nur zwei Streifenleitern bestehende symmetrische oder unsymmetrische Koplanarleitung im Gehäuse vorgesehen sein, in diesem Fall sind dann auch nur zwei Nadeln 12 vorgesehen, die eine symmetrische bzw. unsymmetrische Zweipunkt-Meßsignalaufnahme ermöglichen.

Die Ausbildung der Kontaktspitzen als dünne elastische Nadeln aus einem elastischen Federstahlmaterial gewährleistet, daß die Meßspitzen unter dem Mikroskop sehr genau fokusiert und auf den extrem kleinen Kontaktstellen von nur 10 bis 200 µm der zu vermessenden Mikrowellenschaltung aufgesetzt werden können. Da sie nachgiebig elastisch verformbar sind ist auch ihr Verschleiß minimal und auch die Gefahr des Nadelbruches gering.

Im Gehäuse 1 der Meßspitzeneinheit E können gegebenenfalls auch andere passive und/oder aktive Schaltungen eingebaut werden, die für den Betrieb der Meßspitzeneinheit benötigt werden. So können beispielsweise auf dem Substrat 3 Schaltungen zur Gleichspannungszuführung über die Meßspitzen zum Meßobjekt vorgesehen sein, die über seitlich am Gehäuse herausgeführte Leitungen mit außen angeordneten Geräten verbunden sind.

Eine andere Möglichkeit, wie bei einer erfindungsgemäßen Meßspitzeneinheit E unmittelbar Schaltungsteile eines vektoriellen Netzwerkanalysators in die Meßspitzeneinheit integriert werden können, zeigt Fig. 3. Hier ist der Meßaufbau zum Messen eines Meßobjekts 21, beispielsweise eines Spannungsverstärkers für hohe Frequenzen, mittels eines vektoriellen Netzwerkanalysators 22 gezeigt.

In den Gehäusen 1 der Meßspitzeneinheiten E1 und E2 sind unmittelbar die schematisch angedeuteten Meßstellen m1 bis m4 des Netzwerkanalysators integriert. Diese Meßstellen bestehen beispielsweise aus frequenzumsetzenden Bauelementen wie Mischer, Verstärker, Analog/Digital-Wandler und dergleichen aktiven und passiven Bauelementen, die damit über die Koplanarleitung möglichst nahe am Meßobjekt angeschaltet sind, was insbesondere für Messungen im Höchstfrequenzbereich von Vorteil ist. In ähnlicher Weise können in den Gehäusen der Meßspitzeneinheiten auch zusätzliche andere Baugruppen wie Generatoren, Rauschquellen oder dergleichen integriert werden, die dann unmittelbar in der Nähe des Meßobjekts mit der Koplanarleitung verbunden sind und die gegebenenfalls über vom Gehäuse nach außen geführte Zuleitungen mit anderen Geräten verbunden sind.

Der Meßaufbau nach Fig. 3 zeigt außerdem, wie durch Impedanztransformationsschaltungen in Form von Widerstandsnetzwerken 23 und 24, die in den Meßspitzeneinheiten E1 und E2 integriert sind, die jeweils zweckmäßigsten Eingangsimpedanzen zwischen den Meßspitzen der Nadeln 12 wählbar sind, mit denen die entsprechenden Ein- und Ausgangs-Anschlüsse des Meßobjekts 21 kontaktiert werden. In dem gezeigten Ausführungsbeispiel ist der Abstand der Kontaktspitzen der Meßspitzeneinheit E1 und die Impedanztransformationsschaltung 23 so dimensioniert, daß zwischen den Nadeln 12 eine Eingangsimpedanz von kleiner 100 Ω herrscht, obwohl die Meßspitzeneinheit E1 über ein 50 Ω-Koaxialkabel mit dem Netzwerkanalysator 22 verbunden ist. Ausgangsseitig wird beim Messen des Meßobjekts 21 eine hochohmige Eingangsimpedanz der Meßspitzeneinheit E2 gewünscht, die Meßspitzen der Einheit E2 sind daher in einem entsprechend größeren Abstand voneinander angeordnet und das Impedanztransformationsnetzwerk 24 ist so dimensioniert, daß eine Eingangsimpedanz von beispielsweise 10 kΩ besteht.

Fig. 4 und 5 zeigen erfindungsgemäße Ausführungsformen für den Übergang von einem Koaxialleitungsanschluß 2 auf eine Koplanarleitung. Fig. 4 zeigt dabei den Übergang auf eine symmetrische Drei-Streifenleiter-Koplanarleitung, Fig. 5 zeigt den Übergang auf eine unsymmetrische Zwei-Streifenleiter-Koplanarleitung.

Gemäß Fig. 4 ist der Außenleiter 30 des Koaxialleitungsanschlusses 2 gespalten und läuft aus in zwei gegenüberliegenden, sich allmählich verjüngenden dreieckförmigen Abschnitten 31, 32, deren Enden 35, 36 außerdem leicht nach innen aufeinander zu abgebogen sind. Der Innenleiter 34 ist konisch verjüngt. Durch diese Formgebung des Außen- und Innenleiters wird erreicht, daß das am koaxialseitigen Ende radialsymmetrische elektromagnetische Feld allmählich übergeht in die Feldverteilung einer Koplanarleitung, die zwischen den verjüngten Enden 35, 36 der gegenüberliegenden Außenleiter-Abschnitte 31, 32 und dem in einer Ebene damit liegenden verjüngten Ende 37 des Innenleiters gebildet wird. Die Enden 35, 36, 37 sind über Anschlußfahnen 8, 9, 10 unmittelbar mit den auf dem Substrat 3 ausgebildeten Streifenleitern 5, 6, 7 der Koplanarleitung 4 verbunden.

Bei dem unsymmetrischen Übergang nach Fig. 5 ist der Innenleiter 41 innerhalb des zylindrischen Außenleiters 30 konisch verjüngt ausgebildet und aus seiner Mittelachse 42 exzentrisch seitlich nach außen bis nahe an die Innenwand des Außenleiters 30 so abgebogen, daß auch hier das radial-symmetrische elektromagnetische Feld des Koaxialleitungsanschlusses 2 allmählich in das unsymmetrische elektromagnetische Feld einer unsymmetrischen Koplanarleitung übergeht. Das verjüngte Ende 43 des Innenleiters ist über eine Anschlußfahne 44 mit der schmalen Leiterbahn 45 einer unsymmetrischen Koplanarleitung und der Außenleiter 30 über eine in der gleichen Ebene wie die Fahne 44 angeordnete Anschlußfahne 46 mit dem breiteren Streifenleiter 47 der Koplanarleitung verbunden. Diese in den Fig. 4 und 5 dargestellten Übergänge von einer Koaxialleitung auf Koplanarleitungen sind nicht nur für den erfindungsgemäßen Zweck bei einer Meßspitzeneinheit E nach Fig. 1 verwendbar, sondern in gleicher Weise geeignet für Übergangsstecker und dergleichen.

## Patentansprüche

1. Messspitzeneinheit (E) zum Kontaktieren von planaren Mikrowellenschaltungen (M) mit einem Gehäuse (1) und einer in diesem Gehäuse (1) angeordneten Koplanarleitung (4; 5, 6, 7; 45, 47), an deren einem Ende eine Koaxialleitung (2) und an deren anderem Ende mindestens zwei vom Gehäuse abstehende Kontaktspitzen angeschlossen sind,
**dadurch gekennzeichnet,**
**dass** die Kontaktspitzen durch dünne, im Abstand nebeneinander angeordnete Nadeln (12) gebildet sind, die nebeneinander in einem Körper (13) aus Isoliermaterial eingesetzt und mit ihren inneren Enden mit den Streifenleitern (5, 6, 7; 45, 47) der Koplanarleitung (4) elektrisch verbunden sind, wobei der die Nadeln (12) aufnehmende Isolierkörper (13) in einer Öffnung (11) des Gehäuses (1) lösbar befestigt ist.

2. Messspitzeneinheit nach Anspruch 1,
**dadurch gekennzeichnet,**
**dass** die Nadel (12) konisch spitz zulaufend ausgebildet und mit ihren äußeren Enden (16) auf einen Brennpunkt zulaufend angeordnet sind.

3. Messspitzeneinheit nach Anspruch 1 oder 2,
**dadurch gekennzeichnet,**
**dass** die Nadeln (12) außerhalb des Gehäuses nur durch Luft voneinander getrennt sind.

4. Messspitzeneinheit nach einem der vorhergehenden Ansprüche,
**dadurch gekennzeichnet,**
**dass** die inneren Enden der Nadeln (12) nur mit Druck auf der Oberfläche der Streifenleiter der Koplanarleitung aufliegen.

5. Messspitzeneinheit nach einem der vorhergehenden Ansprüche,
**dadurch gekennzeichnet,**
**dass** die Nadeln (12) aus einem elastischen Federstahlmaterial bestehen.

6. Messspitzeneinheit nach einem der vorhergehenden Ansprüche,
**dadurch gekennzeichnet,**
**dass** der Durchmesser und der gegenseitige Abstand der nebeneinander angeordneten Nadeln (12) unter Berücksichtigung der die Elektrizitätskonstante des zwischen den Nadeln vorhandenen Dielektrikums so gewählt ist, dass zwischen den Nadelspitzen eine für den jeweiligen Anwendungsfall vorbestimmte Impedanz besteht.

7. Messspitzeneinheit nach einem der vorhergehenden Ansprüche,
**dadurch gekennzeichnet,**
**dass** die Spitzen der Nadeln (12) derart meißelförmig angeschrägt sind, dass sie beim Aufsetzen auf eine zu kontaktierende planare Mikrowellenschaltung (M) mit dieser einen Flächenkontakt herstellen.

8. Messspitzeneinheit nach einem der vorhergehenden Ansprüche,
**dadurch gekennzeichnet,**
**dass** die Koplanarleitung (4) als symmetrische Dreibandleitung (5, 6, 7) ausgebildet ist und die Kontaktspitzeneinheit (K) aus drei Kontaktspitzen (12) besteht.

9. Messspitzeneinheit nach einem der vorhergehenden Ansprüche,
**dadurch gekennzeichnet,**
**dass** die Koplanarleitung (4) als symmetrische Zweibandleitung ausgebildet ist und die Kontaktspitzeneinheit (K) aus zwei Kontaktspitzen (12) besteht.

10. Messspitzeneinheit nach einem der vorgehenden Ansprüche,
**dadurch gekennzeichnet,**
**dass** die Koplanarleitung (4) als unsymmetrische Koplanarleitung (45, 47) ausgebildet ist und die Kontaktspitzeneinheit (K) aus zwei Kontaktspitzen (12) besteht.

11. Messspitzeneinheit nach einem der vorhergehenden Ansprüche,
**dadurch gekennzeichnet,**
**dass** auf dem Substrat (3) zusätzliche mit der Koplanarleitung (4) verbundene passive und/oder aktive Schaltungen (m₁ bis m₄; 23,24) ausgebildet sind.

12. Messspitzeneinheit nach Anspruch 11,
**dadurch gekennzeichnet,**
**dass** in der Koplanarleitung (4) eine Impedanztransformationsschaltung angeordnet ist.

13. Messspitzeneinheit nach einem der vorhergehenden Ansprüche für einen vektoriellen Netzwerkanalysator (22),
**dadurch gekennzeichnet,**
**dass** ein Teil der Betriebsschaltung des Netzwerkanalysators unmittelbar auf dem Substrat (3) ausgebildet ist.

14. Messspitzeneinheit nach Anspruch 8,
**dadurch gekennzeichnet,**
**dass** der zylindrische Außenleiter (30) der Koaxialleitung sich aufspaltet und in zwei gegenüberliegende sich allmählich verjüngenden und aufeinander zu gebogenen dreieckförmigen Seitenabschnitten (31, 32) ausläuft, der zylindrische Innenleiter (34) sich kegelförmig verjüngt und die verjüngten Enden (35, 36, 37) der Außenleiter-Seitenabschnitte (31, 32) und des Innenleiters (37) in einer Ebene nach Art einer Dreileiter-Koplanarleitung nebeneinander angeordnet und mit der Dreileiter-Koplanarleitung (4, 5, 6, 7) verbunden sind.

15. Messspitzeneinheit nach Anspruch 9,
**dadurch gekennzeichnet,**
**dass** der Innenleiter (41) der Koaxialleitung sich konisch verjüngt, aus seiner Mittelachse (42) allmählich seitlich in Richtung Außenleiter (30) abgebogen ist und am verjüngten Ende (43) des Innenleiters und in einer Ebene damit am Rand des zylindrischen Außenleiters (30) jeweils Anschlussfahnen (44, 46) ausgebildet sind, die mit der Zweileiter-Koplanarleitung (45, 47) verbunden sind.

## Claims

1. Test-probe unit (E) for contacting planar microwave circuits (M), comprising a housing (1) and a coplanar line (4; 5, 6, 7; 45, 47) arranged in this housing, at one end of which, a coaxial line (2) is connected, and at the other end of which at least two contact tips projecting from the housing are connected,
**characterised in that**
the contact tips are formed by thin needles (12) arranged side by side at a distance, which are inserted side by side in a body (13) made from insulating material and electrically connected by their internal ends to the striplines (5, 6, 7; 45, 47) of the coplanar line (4), wherein the insulating body (13) holding the needles (12) is mounted in a detachable manner in an opening (11) of the housing (1).

2. Test-probe unit according to claim 1,
**characterised in that**
the needles (12) are formed in a conically tapering manner and arranged with their external ends (16) tapering towards a focal point.

3. Test-probe unit according to claim 1 or 2,
**characterised in that**,
outside the housing, the needles (12) are separated from one another only by air.

4. Test-probe unit according to any one of the preceding claims,
**characterised in that**
the internal ends of the needles (12) contact the surface of the striplines of the coplanar line only by pressure contact.

5. Test-probe unit according to any one of the preceding claims,
**characterised in that**
the needles (12) consist of a resilient spring-steel material.

6. Test-probe unit according to any one of the preceding claims,
**characterised in that**
the diameter and the distance between the needles (12) arranged side by side is selected, taking into consideration the dielectric constant of the dielectric existing between the needles, in such a manner that an impedance pre-determined for each application is provided between the needle tips.

7. Test-probe unit according to any one of the preceding claims,
**characterised in that**
the tips of the needles (12) are bevelled into a chisel-shape so that they form a surface contact with a planar microwave circuit (M) to be contacted when they are placed onto the latter.

8. Test-probe unit according to any one of the preceding claims,
**characterised in that**
the coplanar line (4) is formed as a symmetrical three-strip line (5, 6, 7), and the contact-tip unit (K) consists of three contact tips (12).

9. Test-probe unit according to any one of the preceding claims,
**characterised in that**
the coplanar line (4) is formed as a symmetrical two-strip line and the contact-tip unit (K) consists of two contact tips (12).

10. Test-probe unit according to any one of the preceding claims,
**characterised in that**
the coplanar line (4) is formed as an asymmetrical coplanar line (45, 47), and the contact-tip unit (K) consists of two contact tips (12).

11. Test-probe unit according to any one of the preceding claims,
**characterised in that**
additional passive and/or active circuits (m1 to m4; 23, 24) connected to the coplanar line (4) are formed on the substrate (3).

12. Test-probe unit according to claim 11,
**characterised in that**
an impedance-transformation circuit is arranged in the coplanar line (4).

13. Test-probe unit according to any one of the preceding claims for a vectorial network analyser (22),
**characterised in that**
part of the operating circuit of the network analyser is formed directly on the substrate (3).

14. Test-probe unit according to claim 8,
**characterised in that**
the cylindrical outer conductor (30) of the coaxial line is split and merges into two opposing, triangular, lateral portions (31, 32) gradually converging and curved towards one another, that the cylindrical inner conductor (34) tapers in a conical manner and that the tapering ends (35, 36, 37) of the lateral portions (31, 32) of the outer conductor and of the inner conductor (37) are arranged side by side in one plane in the form of a three-conductor coplanar line and connected to the three-conductor coplanar line (4; 5, 6, 7).

15. Test-probe unit according to claim 9,
**characterised in that**
the inner conductor (41) of the coaxial line tapers conically and gradually curves laterally away from its central axis (42) towards the outer conductor (30), and that connecting lugs (44, 46), which are connected to the two-conductor coplanar line (45, 47), are formed in each case at the tapering end (43) of the inner conductor and in one plane with it at the edge of the cylindrical outer conductor (30).

## Revendications

1. Unité de pointes de mesure (E) pour la mise en contact avec des circuits à micro-ondes planaires (M), avec un boîtier (1) et une ligne coplanaire (4; 5, 6, 7; 45, 47) disposée dans ce boîtier (1), à une extrémité de laquelle est raccordée une ligne coaxiale (2) et à l'autre extrémité de laquelle sont raccordées au moins deux pointes de contact partant du boîtier,
**caractérisé en ce que**
les pointes de contact sont formées par des aiguilles (12) fines disposées à distance les unes à côté des autres qui sont insérées les unes à côté des autres dans un corps (13) fait en un matériau isolant et qui sont reliées électriquement aux microbandes (5, 6, 7; 45, 47) de la ligne coplanaire (4) par leur extrémités intérieures, le corps isolant (13) recevant les aiguilles (12) étant fixé de manière amovible dans une ouverture (11) du boîtier (1).

2. Unité de pointes de mesure selon la revendication 1,
**caractérisée en ce que**
les aiguilles (12) se terminent en pointe conique et sont disposées avec leurs extrémités extérieures (16) se terminant dans un point d'inflammation.

3. Unité de pointes de mesure selon la revendication 1 ou 2,
**caractérisée en ce que**
les aiguilles (12) à l'extérieur du boîtier sont simplement séparées par de l'air.

4. Unité de pointes de mesure selon l'une quelconque des revendications précédentes,
**caractérisée en ce que**
les extrémités intérieures des aiguilles (12) sont posées seulement par pression sur la surface des microbandes de la ligne coplanaire.

5. Unité de pointes de mesure selon l'une quelconque des revendications précédentes,
**caractérisée en ce que**
les aiguilles (12) sont constituées d'un matériau d'acier à ressort élastique.

6. Unité de pointes de mesure selon l'une quelconque des revendications précédentes,
**caractérisée en ce que**
le diamètre et la distance entre les aiguilles (12) disposées les unes à côté des autres sont choisis en tenant compte de la constante d'électricité du diélectrique présent entre les aiguilles de manière à ce qu'une impédance prédéterminée pour l'utilisation correspondante soit présente entre les pointes des aiguilles.

7. Unité de pointes de mesure selon l'une quelconque des revendications précédentes,
**caractérisée en ce que**
les pointes des aiguilles (12) sont biseautées en forme de burin de manière à ce que, lorsqu'elles sont posées sur un circuit à micro-ondes planaire (M) avec lequel elles doivent faire contact, elles établissent un contact superficiel avec celui-ci.

8. Unité de pointes de mesure selon l'une quelconque des revendications précédentes,
**caractérisée en ce que**
la ligne coplanaire (4) est configurée comme une ligne symétrique à trois bandes (5, 6, 7) et la pointe de contact (K) est constituée de trois pointes de contact (12).

9. Unité de pointes de mesure selon l'une quelconque des revendications précédentes,
**caractérisée en ce que**
la ligne coplanaire (4) est configurée comme une ligne symétrique à deux bandes et la pointe de contact (K) est constituée de deux pointes de contact (12).

10. Unité de pointes de mesure selon l'une quelconque des revendications précédentes,
**caractérisée en ce que**
la ligne coplanaire (4) est configurée comme une ligne asymétrique (45, 47) et la pointe de contact (K) est constituée de deux pointes de contact (12).

11. Unité de pointes de mesure selon l'une quelconque des revendications précédentes,
**caractérisée en ce que**
des circuits passifs et/ou actifs (m₁ à m₄; 23, 24) supplémentaires, reliés à la ligne coplanaire (4) sont formés sur le substrat (3).

12. Unité de pointes de mesure selon la revendication 11,
**caractérisée en ce que**
un circuit de transformation d'impédance est disposé dans la ligne coplanaire (4).

13. Unité de pointes de mesure selon l'une quelconque des revendications précédentes pour un analyseur de réseau vectoriel (22),
**caractérisée en ce que**
une partie du circuit de fonctionnement de l'analyseur de réseau est formée directement sur le substrat (3).

14. Unité de pointes de mesure selon la revendication 8,
**caractérisée en ce que**
le conducteur extérieur cylindrique (30) de la ligne coaxiale se dédouble et se termine par deux segments latéraux rectangulaires opposés (31, 32) s'amincissant progressivement et recourbés les uns vers les autres, le conducteur intérieur cylindrique (34) s'amincit en forme de cône et les extrémités amincies (35, 36, 37) des segments latéraux du conducteur extérieur (31, 32) et du conducteur intérieur (37) sont disposées les unes à côté des autres dans un plan à la manière d'une ligne coplanaire à trois conducteurs et sont reliées à la ligne coplanaire à trois conducteurs (4, 5, 6, 7).

15. Unité de pointes de mesure selon la revendication 9,
**caractérisée en ce que**
le conducteur intérieur (41) de la ligne coaxiale s'amincit en forme de cône, est recourbé progressivement latéralement dans la direction du conducteur extérieur cylindrique (30) à partir de son axe médian (42) et des barrettes de raccordement (44, 46), qui sont reliées à la ligne coplanaire à deux conducteurs (45, 47), sont formées à l'extrémité amincie (43) du conducteur intérieur et au même niveau sur le bord du conducteur extérieur cylindrique (30).
